(19) Europäisches Patentamt
European Patent Office
Office européen des brevets

(11) EP 4 474 431 A1

# (12) EUROPEAN PATENT APPLICATION
published in accordance with Art. 153(4) EPC

(43) Date of publication:
**11.12.2024 Bulletin 2024/50**

(21) Application number: **23747170.1**

(22) Date of filing: **31.01.2023**

(51) International Patent Classification (IPC):
***C08L 101/00*** *(2006.01)* ***H05K 1/03*** *(2006.01)*

(52) Cooperative Patent Classification (CPC):
**C08L 101/00; H05K 1/03**

(86) International application number:
**PCT/JP2023/003007**

(87) International publication number:
**WO 2023/145960 (03.08.2023 Gazette 2023/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.01.2022 JP 2022013621**

(71) Applicant: **Daicel Corporation**
**Osaka-shi, Osaka 530-0011 (JP)**

(72) Inventors:
- **ITO, Daisuke**
**Tokyo 108-8230 (JP)**
- **ISHIKAWA, Shinsuke**
**Tokyo 108-8230 (JP)**
- **FUJIOKA, Yuichi**
**Tokyo 108-8230 (JP)**
- **MUTSUDA, Mitsuteru**
**Tokyo 108-8230 (JP)**
- **KITAGAWA, Tomoki**
**Tokyo 108-8230 (JP)**

(74) Representative: **Müller-Boré & Partner Patentanwälte PartG mbB**
**Friedenheimer Brücke 21**
**80639 München (DE)**

## (54) THERMOSETTING RESIN COMPOSITION, RESIN COMPOSITION FOR PRINTED WIRING BOARD, AND RESIN COMPOSITION FOR PRINTED WIRING BOARD SUBSTRATE

(57) The present disclosure provides a thermosetting resin composition and the like, from which is obtained a cured product that excels in dielectric properties with respect to high-frequency radio waves. The thermosetting resin composition and the like of the present disclosure contain a thermosetting resin having a plurality of ethylenically unsaturated groups per molecule. The ethylenically unsaturated groups are carbon-carbon double bonds each containing two carbon atoms. A percentage of a number of ethylenically unsaturated groups in which both of the two carbon atoms are bonded to one or two atoms other than a hydrogen atom by single bonds is 50% or greater, with proviso that the total number of the ethylenically unsaturated groups is 100%. Alternatively, a dielectric loss tangent at 40 GHz of a cured product of the thermosetting resin composition is smaller than a dielectric loss tangent at 10 GHz of the cured product.

EP 4 474 431 A1

## Description

### Technical Field

The present disclosure relates to a thermosetting resin composition, a resin composition for a printed wiring board, and a resin composition for a printed wiring board substrate.

### Background Art

A cured product of a curable resin composition has been used as an insulating member configuring a printed wiring board or the like (for example, see Patent Documents 1 and 2).
Patent Document 1: JP 2021-47305 A
Patent Document 2: JP H06-128352 A

### Summary of Invention

Next-generation mobile communication systems (for example, a sixth generation mobile communication system (6G) (radio waves: for example, from 100 GHz to 3 THz)) that use high-frequency radio waves (for example, 100 GHz or higher) may require the use of printed circuit boards with lower transmission loss than ever before. That is, printed wiring boards having better dielectric properties than ever before may be required.
However, a cured product configuring a printed wiring board having excellent dielectric properties with regard to high-frequency radio waves has not been sufficiently examined thus far.
In addition, a cured product having excellent dielectric properties with regard to high-frequency radio waves may be required not only in applications in printed wiring boards, but in other applications as well.
Accordingly, an object of the present disclosure is to provide a thermosetting resin composition, a resin composition for a printed wiring board, and a resin composition for a printed wiring board substrate, by which can be obtained a cured product having excellent dielectric properties with regard to high-frequency radio waves.
As a result of intensive studies, the present inventors discovered that a cured product of a thermosetting resin composition containing a predetermined thermosetting resin exhibits excellent dielectric properties.
The present disclosure includes the following aspects.

[1] First Aspect

[1-1] A thermosetting resin composition including a thermosetting resin, the thermosetting resin including a plurality of ethylenically unsaturated groups per molecule,

wherein each of the plurality of ethylenically unsaturated groups is a carbon-carbon double bond including two carbon atoms,
a percentage of a number of ethylenically unsaturated groups in which both of two carbon atoms are bonded to one or two atoms other than a hydrogen atom by single bonds is 50% or greater, with proviso that a total number of ethylenically unsaturated groups of the thermosetting resin composition is 100%, and
a dielectric loss tangent at 40 GHz of a cured product of the thermosetting resin composition is smaller than a dielectric loss tangent at 10 GHz of the cured product.

[1-2] The thermosetting resin composition according to [1-1], further containing a compound having two or more polymerizable conjugated double bonds per molecule.
[1-3] The thermosetting resin composition according to [1-2], wherein the compound having two or more polymerizable conjugated double bonds per molecule contains a compound having a styryl group.
[1-4] The thermosetting resin composition according to [1-3], wherein the compound having a styryl group contains one or more compounds selected from the group consisting of divinylbenzene, 1,2-bis(vinylphenyl) ethane, 1,4-bis(vinylphenyl)butane, and modified polyphenylene ether resins having two styryl groups per molecule.
[1-5] The thermosetting resin composition according to any one of [1-1] to [1-4], wherein the thermosetting resin composition includes a thermosetting component containing the thermosetting resin, and
the thermosetting component contains the thermosetting resin at an amount of 50 wt.% or greater.
[1-6] The thermosetting resin composition according to any one of [1-1] to [1-5], wherein the dielectric loss tangent

at the 40 GHz of a cured product of the thermosetting resin composition is $8.0 \times 10^{-3}$ or less.

[1-7] The thermosetting resin composition according to any one of [1-1] to [1-6], wherein the one or two atoms other than a hydrogen atom are carbon atoms.

[1-8] The thermosetting resin composition according to any one of [1-1] to [1-7], wherein the thermosetting resin includes one or more resins selected from the group consisting of polyoctenylenes, styrene-butadiene-styrene block copolymers, and ethylene-propylene-diene copolymers.

[1-9] The thermosetting resin composition according to [1-8], wherein the thermosetting resin includes a polyoctenylene.

[1-10] The thermosetting resin composition according to [1-8], wherein the thermosetting resin includes a styrene-butadiene-styrene block copolymer.

[1-11] The thermosetting resin composition according to [1-8], wherein the thermosetting resin includes an ethylene-propylene-diene copolymer.

[1-12] The thermosetting resin composition according to any one of [1-1] to [1-7], wherein the thermosetting resin includes a polyisoprene.

[1-13] The thermosetting resin composition according to any one of [1-1] to [1-12], wherein the thermosetting resin is substantially free of an epoxy group.

[1-14] The thermosetting resin composition according to any one of [1-1] to [1-13], wherein the thermosetting resin composition further contains a radical polymerization initiator.

[2] Second Aspect

[2-1] A thermosetting resin composition including a thermosetting component containing a thermosetting resin, the thermosetting resin including a plurality of ethylenically unsaturated groups per molecule,

wherein

a percentage of a number of ethylenically unsaturated groups in which both of two carbon atoms constituting a carbon-carbon double bond of an ethylenically unsaturated group are bonded to one or two atoms other than a hydrogen atom by single bonds is 50% or greater, with proviso that a total number of ethylenically unsaturated groups of the thermosetting resin composition is 100%.

[2-2] The thermosetting resin composition according to [2-1], wherein the thermosetting component contains the thermosetting resin at an amount of 20 wt.% or greater.

[2-3] The thermosetting resin composition according to [2-1] or [2-2], wherein a trans-conformation percentage of the thermosetting resin is 30% or greater.

[2-4] The thermosetting resin composition according to any one of [2-1] to [2-3], wherein the thermosetting resin includes one or more resins selected from the group consisting of polyoctenylenes, styrene-butadiene-styrene block copolymers, and ethylene-propylene-diene copolymers.

[2-5] The thermosetting resin composition according to [2-4], wherein the thermosetting resin contains a polyoctenylene.

[2-6] The thermosetting resin composition according to [2-4], wherein the thermosetting resin contains a styrene-butadiene-styrene block copolymer.

[2-7] The thermosetting resin composition according to [2-4], wherein the thermosetting resin contains an ethylene-propylene-diene copolymer.

[2-8] The thermosetting resin composition according to any one of [2-1] to [2-3], wherein the thermosetting resin contains a polyisoprene.

[2-9] The thermosetting resin composition according to any one of [2-1] to [2-8], wherein the thermosetting component further contains a compound having two or more polymerizable conjugated double bonds per molecule.

[2-10] The thermosetting resin composition according to [2-9], wherein the compound having two or more polymerizable conjugated double bonds per molecule includes a compound having a styryl group.

[2-11] The thermosetting resin composition according to [2-10], wherein the compound having a styryl group includes one or more compounds selected from the group consisting of divinylbenzene, 1,2-bis(vinylphenyl) ethane, 1,4-bis(vinylphenyl)butane, and modified polyphenylene ether resins having two styryl groups per molecule.

[2-12] The thermosetting resin composition according to any one of [2-1] to [2-11], wherein the dielectric loss tangent at a 40 GHz of a cured product of the thermosetting resin composition is $8.0 \times 10^{-3}$ or less.

[2-13] The thermosetting resin composition according to any one of [2-1] to [2-12], wherein the dielectric loss tangent at a 40 GHz of the cured product of the thermosetting resin composition is smaller than a dielectric loss tangent at 10 GHz of the cured product.

[2-14] The thermosetting resin composition according to any one of [2-1] to [2-13], wherein the one or two atoms

other than a hydrogen atom are carbon atoms.
[2-15] The thermosetting resin composition according to any one of [2-1] to [2-14], wherein the thermosetting resin is substantially free of an epoxy group.
[2-16] The thermosetting resin composition according to any one of [2-1] to [2-15], wherein the thermosetting resin composition further includes a radical polymerization initiator.

[3] Third Embodiment

[3-1] A resin composition for a printed wiring board, the resin composition including the thermosetting resin composition described in any one of [1-1] to [1-14] and [2-1] to [2-16].
[3-2] A resin composition for a printed wiring board, the resin composition including the thermosetting resin composition described in any one of [1-1] to [1-14] and [2-1] to [2-16].
[3-3] Use of the thermosetting resin composition described in any one of [1-1] to [1-14] and [2-1] to [2-16], as a resin composition for a printed wiring board.
[3-4] Use of the thermosetting resin composition described in any one of [1-1] to [1-14] and [2-1] to [2-16], for producing a printed wiring board.

[4] Fourth Aspect

[4-1] A resin composition for a printed wiring board substrate, the resin composition being the thermosetting resin composition described in any one of [1-1] to [1-14] and [2-1] to [2-16], wherein

the resin composition is used for producing a printed wiring board, the printed wiring board being a laminate in which a substrate and a pattern film are laminated, and
the resin composition is used for producing the substrate.

[4-2] The thermosetting resin composition according to any one of [1-1] to [1-14] and [2-1] to [2-16], wherein
the thermosetting resin is used for producing a substrate of a printed wiring board, the printed wiring board being a laminate in which the substrate and a pattern film are laminated.
[4-3] The thermosetting resin composition according to any one of [1-1] to [1-15] and [2-1] to [2-16], wherein
the thermosetting resin is used for producing a pattern film in a printed wiring board, the printed wiring board being a laminate in which a substrate and the pattern film are laminated.
[4-4] A printed wiring board including:

a substrate including a cured product of the thermosetting resin composition described in any one of [1-1] to [1-14] and [2-1] to [2-16] and;
a pattern film,
wherein the substrate and the pattern film are laminated.

[4-5] A printed wiring board including:

a pattern film including a cured product of the thermosetting resin composition described in any one of [1-1] to [1-14] and [2-1] to [2-16]; and
a substrate,
wherein the substrate and the pattern film are laminated.

[4-6] Use of the thermosetting resin composition described in any one of [1-1] to [1-14] and [2-1] to [2-16] for producing a substrate of a printed wiring board, the printed wiring board being a laminate in which the substrate and a pattern film are laminated.
[4-7] Use of the thermosetting resin composition described in any one of [1-1] to [1-14] and [2-1] to [2-16] for producing a pattern film in a printed wiring board, the printed wiring board being a laminate in which a substrate and the pattern film are laminated.

According to the present disclosure, the cured product has excellent dielectric properties with respect to high-frequency radio waves.

## Description of Embodiments

Hereinafter, embodiments of the present disclosure will be described.
It should be noted that the respective configurations and the combinations thereof in the respective embodiments are only examples, and configurations may be added, omitted, substituted, or otherwise modified as appropriate within a scope that does not depart from the spirit of the present disclosure. The present disclosure is not limited by the embodiments and is limited only by the claims.
Each aspect disclosed in the present specification can be combined with any other feature disclosed herein.
Where a particular description given for an embodiment also applies to another embodiment, that description may be omitted in the other embodiment. In the present disclosure, the expression "from X to Y" with regard to a numerical range means "X or more and Y or less".

## First Embodiment

### Thermosetting Resin Composition

A thermosetting resin composition according to the present embodiment contains a thermosetting resin.
The thermosetting resin has a plurality of ethylenically unsaturated groups per molecule.
Each of the ethylenically unsaturated groups is a carbon-carbon double bond containing two carbon atoms.
A ratio of a number of ethylenically unsaturated groups in which both of the two carbon atoms are bonded to one or two atoms other than a hydrogen atom by single bonds is 50% or greater, with proviso that a total number of the ethylenically unsaturated groups of the thermosetting resin composition is 100%.
The dielectric loss tangent at 40 GHz of a cured product of the thermosetting resin composition is smaller than the dielectric loss tangent at 10 GHz of the cured product.
The thermosetting resin composition according to the present embodiment contains a thermosetting component containing the thermosetting resin.
In addition, the thermosetting resin composition according to the present embodiment preferably further contains a radical polymerization initiator.
The thermosetting resin composition according to the present embodiment may further contain an additive.
The thermosetting resin composition according to the present embodiment may further contain an organic solvent that dissolves the thermosetting component.
The thermosetting resin composition according to the present embodiment may be in a liquid form, with an organic solvent contained.
The thermosetting resin composition according to the present embodiment may also be in a solid form.

### Thermosetting Component

The thermosetting component contains the thermosetting resin.
In an embodiment, the thermosetting component preferably further contains a compound having two or more polymerizable conjugated double bonds per molecule.
The thermosetting resin has a plurality of ethylenically unsaturated groups per molecule.
Each of the ethylenically unsaturated groups is a carbon-carbon double bond containing two carbon atoms. The carbon-carbon double bond may be a polymerizable carbon-carbon double bond. In addition, the carbon-carbon double bond may be a non-conjugated double bond. In an embodiment, the ethylenically unsaturated groups are preferably in the main chain of the thermosetting resin. In an embodiment, the ethylenically unsaturated groups preferably constitute a part of a chain or a cyclic hydrocarbon group. A thermosetting resin having one or more ethylenically unsaturated groups in one or more constituent units has a plurality of ethylenically unsaturated groups per molecule.
A ratio of the number of ethylenically unsaturated groups in which both of the two carbon atoms are bonded to one or two atoms other than a hydrogen atom by single bonds is 50% or greater, preferably 70% or greater, more preferably 80% or greater, and still more preferably 90% or greater, with proviso that the total number of the ethylenically unsaturated groups is 100%.
The ratio of the number of ethylenically unsaturated groups in which both of the two carbon atoms are bonded to one or two atoms other than a hydrogen atom by single bonds when the total number of the ethylenically unsaturated groups is 100% can be determined by dissolving the thermosetting resin in deuterated chloroform to produce a solution, and then analyzing the solution using a 1H-NMR spectrometer.
Note that, for example, when both of the two carbon atoms of the ethylenically unsaturated group are bonded to one ethylene group ($-CH_2CH_2-$) by single bonds, a peak of the ethylenically unsaturated groups in which both of the carbon atoms are bonded to one or two atoms other than hydrogen by single bonds is observed in the 1H-NMR spectrum from 5.3

ppm to 5.4 ppm.

In addition, peaks of ethylenically unsaturated groups in which one of the carbon atoms is bonded to two hydrogen atoms by single bonds are observed in the 1H-NMR spectrum at 4.9 ppm and 5.6 ppm.

For example, when both of the two carbon atoms of the ethylenically unsaturated group are bonded to one ethylene group (-$CH_2CH_2$-) by single bonds, it is assumed that the total of the peak area from 5.3 to 5.4 ppm, the peak area at 4.9 ppm, and the peak area at 5.6 ppm is the total number (100%) of ethylenically unsaturated groups, and a ratio of the peak area from 5.3 to 5.4 ppm to the total peak area (the total number) is the "ratio of the number of ethylenically unsaturated groups in which both of the two carbon atoms are bonded to one or two atoms other than hydrogen by single bonds".

The atom other than a hydrogen atom is preferably a carbon atom.

The number of ethylenically unsaturated groups is preferably one per 4 to 16 carbon atoms, more preferably one per 4 to 12 carbon atoms, and even more preferably one per 4 to 8 carbon atoms.

The thermosetting component may contain one thermosetting resin or a plurality of thermosetting resins. The plurality of thermosetting resins may also include, for example, thermosetting resins that are polymers having the same unit structure but different molecular weights.

The thermosetting component may contain only a thermosetting resin, or may further contain other components, and the content of the other components need only be in a range in which the cured product of the thermosetting resin composition exhibits excellent dielectric properties with respect to high-frequency radio waves.

Examples of the thermosetting resin include polyoctenylenes, styrene-butadiene-styrene block copolymers, and ethylene-propylene-diene copolymers. Polyoctenylenes, styrene-butadiene-styrene block copolymers, and ethylene-propylene-diene copolymers become thermosettable when radicals are generated. In an embodiment, the thermosetting resin preferably includes a polyoctenylene. In another embodiment, the thermosetting resin preferably includes one or more selected from the group consisting of styrene-butadiene-styrene block copolymers and ethylene-propylene-diene copolymers.

In an embodiment, the thermosetting resin included in the thermosetting component is preferably a polyoctenylene, a styrene-butadiene-styrene block copolymer, an ethylene-propylene-diene copolymer, or a mixture of one or more thereof.

When the thermosetting resin contained in the thermosetting component is a polyoctenylene, a styrene-butadiene-styrene block copolymer, an ethylene-propylene-diene copolymer, or a mixture of one or more thereof, the dielectric loss tangent of a cured product of the thermosetting resin composition at a high frequency is likely to be small, and/or the dielectric loss tangent of the cured product at a high frequency is likely to be smaller than that at a low frequency.

In another embodiment, the thermosetting resin included in the thermosetting component preferably includes polyisoprene. When the thermosetting resin contained in the thermosetting component contains polyisoprene, the dielectric loss tangent of the cured product of the thermosetting resin composition at a high frequency tends to be small, and/or the dielectric loss tangent of the cured product at a high frequency tends to be smaller than that at a low frequency.

The trans-conformation percentage of each thermosetting resin contained in the thermosetting component is preferably 30% or greater, more preferably from 30 to 99%, even more preferably from 35 to 99%, and yet even more preferably from 37 to 99%. When the trans-conformation percentage is 30% or greater, the trans-conformation percentage may be 37%, 39%, 62%, 64%, 82%, or 99%, or may be in a range in which any one of these values is a lower limit and any other one is an upper limit.

Here, the trans-conformation percentage is the percentage of non-conjugated double bonds having one methylene group or one methyl group at a trans position among all non-conjugated double bonds.

When the trans-conformation percentage of the thermosetting resin is 30% or greater, the dielectric loss tangent of the cured product of the thermosetting resin composition is likely to be small, and/or the dielectric loss tangent of the cured product at a high frequency is likely to be smaller than that at a low frequency. A method for measuring the trans-conformation percentage will be described later.

When the thermosetting component includes one type of polyoctenylene or two or more types of polyoctenylenes having different molecular weights as the thermosetting resin, the trans-conformation percentage of each polyoctenylene is preferably 30% or greater, more preferably from 30 to 90%, even more preferably from 35 to 90%, and yet even more preferably from 35 to 85%. When the trans-conformation percentage is 30% or greater, the trans-conformation percentage may be 39%, 62%, 64%, or 82%, or may be in a range in which any one of these values is a lower limit and any other one is an upper limit.

Here, the thermosetting component including, as the thermosetting resin, one type of polyoctenylene or two or more types of polyoctenylenes of different molecular weights may include a thermosetting resin other than a polyoctenylene (for example, a styrene-butadiene-styrene block copolymer, an ethylene-propylene-diene copolymer, polyisoprene, or the like).

When the trans-conformation percentage of each polyoctenylene is 30% or greater, the dielectric loss tangent of the cured product of the thermosetting resin composition at a high frequency tends to be small, and/or the dielectric loss

tangent of the cured product at a high frequency tends to be smaller than that at a low frequency.

The trans-conformation percentage of the thermosetting component or thermosetting resin can be determined by dissolving the thermosetting component or thermosetting resin in deuterated chloroform to produce a solution and then analyzing the solution with a 1H-NMR spectrometer.

Note that in the 1H-NMR spectrum, the peak of the trans form appears at 5.7 ppm, and the peak of the cis form appears at 5.4 ppm, and the trans-conformation percentage can be determined from the ratio of the peak areas.

The average number of trans double bonds in one molecule of each thermosetting resin contained in the thermosetting component is preferably 5 or greater, more preferably from 5 to 1000, even more preferably from 5 to 750, and yet even more preferably from 5 to 700, and when the average number thereof is from 5 to 700, the average number may be 50, 100, 150, 200, 250, 300, 350, 400, or 450, may be 8, 35, 156, 259, 413, or 700, or may be within a range in which any one of these values is the lower limit and any one other value is the upper limit. When the average number of trans double bonds per molecule of the thermosetting resin is 5 or greater, the dielectric loss tangent of a cured product of the thermosetting resin composition at a high frequency tends to be small, and/or the dielectric loss tangent of the cured product at a high frequency tends to be smaller than that at a low frequency.

The average number of trans double bonds per molecule of the thermosetting resin is determined by the following expression with the assumption that the molecular weight distribution is 2.5.

(Weight average molecular weight of thermosetting resin) $\div$ 2.5 $\div$ (number average molecular weight of repeating unit including one double bond) $\times$ the "trans-conformation percentage of each thermosetting resin included in thermosetting component"

The weight average molecular weight (Mw) and the number average molecular weight (Mn) are values measured from a molecular weight distribution in terms of polystyrene using gel permeation chromatography (GPC) in which a chloroform eluent is used. As a column for use in the GPC, a column appropriate for measuring the molecular weight may be used.

Here, the polyoctenylene is a compound having a repeating constituent unit, and the constituent unit is a constituent unit in which any two adjacent carbon atoms among six carbon atoms in n-octyl form a carbon-carbon double bond. In an embodiment, the polyoctenylene preferably includes poly(1-octenylene).

The carbon-carbon double bond may be either in cis form or trans form. In an embodiment, the carbon-carbon double bond preferably includes a trans form, and thus the trans-conformation percentage of the thermosetting resin is 30% or greater.

Examples of the polyoctenylene include cyclic polyoctenylene (polyoctenylene represented by the following chemical formula (1)) and linear polyoctenylene (polyoctenylene represented by the following chemical formula (2)).

[Chem. 1]

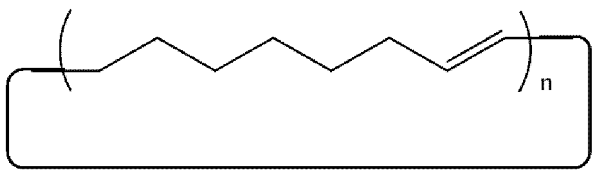

・・・(1)

In the formula (1), n is a natural number and is preferably from 20 to 1200, and may be from 50 to 500.

[Chem. 2]

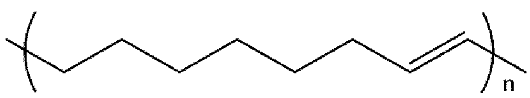

・・・(2)

In the formula (2), n is a natural number and is preferably from 20 to 1200, and may be from 50 to 500.

In the present embodiment, a mixture of cyclic polyoctenylene and linear polyoctenylene may be used as the polyoctenylene.

The polyoctenylene may be produced, for example, by subjecting cyclooctene to ring-opening polymerization or

by subjecting butadiene to metathesis polymerization.

A polyoctenylene of a desired molecular weight may be prepared using a molecular weight regulator according to the method described in WO 2011/160916.

The styrene-butadiene-styrene block copolymer is a block copolymer having a styrene monomer unit and a butadiene monomer unit. A single type of styrene-butadiene-styrene block copolymer may be included or two or more types of styrene-butadiene-styrene block copolymer may be included.

The ethylene-propylene-diene copolymer is a copolymer having an ethylene monomer unit, a propylene monomer unit, and a diene monomer unit. Examples of the diene monomer include 5-ethylidene-2-norbornene, dicyclopentadiene, and 1,4-hexadiene. A single type of ethylene-propylene-diene copolymer may be included or two or more types of ethylene-propylene-diene copolymer may be included.

Polyisoprene is a polymer of isoprene. The polyisoprene may be a homopolymer or a copolymer, but is preferably a homopolymer. Examples of the polyisoprene include cis-1,4-polyisoprene, trans-1,4-polyisoprene, 1,2-polyisoprene, and 3,4-polyisoprene. A single type of polyisoprene may be included, or two or more types of polyisoprene may be included. When a polyisoprene is included, trans-1,4-polyisoprene is preferably included because the dielectric loss tangent of the cured product of the thermosetting resin composition at a high frequency is likely to be small and/or the dielectric loss tangent of the cured product at a high frequency is likely to be smaller than that at a low frequency.

The weight average molecular weight of the thermosetting resin is not limited as long as the weight average molecular weight is within a range at which cured product of the thermosetting resin has a desired dielectric property, but is preferably from $1.0 \times 10^3$ to $1.0 \times 10^6$, and more preferably from $5.0 \times 10^3$ to $5.0 \times 10^5$.

When the thermosetting resin is a polyoctenylene, from the viewpoint of ease of handling of the thermosetting component and/or the thermosetting resin composition, a polyoctenylene having a high molecular weight is preferable, or a polyoctenylene having a low molecular weight is preferably mixed with a polyoctenylene having a high molecular weight.

Here, the high molecular weight polyoctenylene may be, for example, a polyoctenylene having a weight average molecular weight (Mw) of greater than 68000, may be a polyoctenylene having a weight average molecular weight (Mw) of 70000 or greater, 80000 or greater, 90000 or greater, or 100000 or greater, and is preferably a polyoctenylene having a weight average molecular weight (Mw) of 140000 or greater. In the case of a polyoctenylene having a Mw of 140000 or greater, the Mw may be 140000.

On the other hand, the low molecular weight polyoctenylene may be, for example, a polyoctenylene having a Mw of less than 140000, or may be a polyoctenylene having a Mw of 100000 or less, 90000 or less, 80000 or less, or 70000 or less, but is preferably a polyoctenylene having a Mw of 68000 or less. In the case of a polyoctenylene having a Mw of 68000 or less, the Mw may be 68000 or 62000.

Low molecular weight polyoctenylene is in liquid form and is difficult to handle as a thermosetting resin. On the other hand, high molecular weight polyoctenylene or a mixture of a high molecular weight polyoctenylene and a low molecular weight polyoctenylene is not easily liquefied and is easy to handle.

When the thermosetting resin is a polyoctenylene, the thermosetting resin is preferably a mixture in which a high molecular weight polyoctenylene and a low molecular weight polyoctenylene are mixed because the dielectric loss tangent of the cured product of the thermosetting resin composition at a high frequency is likely to be small and/or the dielectric loss tangent of the cured product at a high frequency is likely to be smaller than that at a low frequency.

Note that, in the present embodiment, the weight average molecular weight (Mw) is measured from a molecular weight distribution in terms of polystyrene using gel permeation chromatography (GPC) in which a chloroform eluent is used. As a column for use in the GPC, a column appropriate for measuring the molecular weight may be used.

From the viewpoint of enhancing the dielectric properties of the cured product by lowering the polarity of the thermosetting resin, preferably the thermosetting resin is substantially free of an epoxy group, or preferably free of an epoxy group.

"Substantially free of" refers to a content that does not significantly affect the physical properties of the thermosetting resin or the thermosetting resin composition, and means, for example, that epoxy groups having an epoxy equivalent of 10000 g/eq or greater are not contained in the one or more thermosetting resins contained in the thermosetting component.

Compound Having Two or More Polymerizable Conjugated Double Bonds Per Molecule

In an embodiment, from the viewpoint of increasing heat resistance of the cured product, the thermosetting component preferably further contains a compound having two or more polymerizable conjugated double bonds per molecule.

The thermosetting component contains the compound having two or more polymerizable conjugated double bonds per molecule at an amount of preferably from 10 to 50 wt.%, more preferably from 15 to 45 wt.%, and even more preferably from 20 to 40 wt.%.

The reason why the heat resistance of the cured product is enhanced by further containing the compound having

two or more polymerizable conjugated double bonds per molecule in the thermosetting component is considered to be as follows.

Namely, it is conceivable that since the thermosetting component has two or more polymerizable conjugated double bonds per molecule, the reactivity of the curing reaction increases, and the heat resistance of the cured product is enhanced. In addition, it is conceivable that when the thermosetting component further contains a compound having two or more polymerizable conjugated double bonds per molecule, crosslinking proceeds three dimensionally in a curing reaction to form a strong skeleton, and thus the heat resistance of the cured product is enhanced.

The compound having two or more polymerizable conjugated double bonds per molecule has a functional group having a polymerizable conjugated double bond.

Examples of the functional group having a polymerizable conjugated double bond include a styryl group, a maleimide group, an acrylate group, and a methacrylate group.

The styryl group is a functional group in which an aromatic ring and a $CH_2$=CH- group are bonded. In the styryl group, two or more $CH_2$=CH- groups may be bonded to one aromatic ring.

The compound having two or more polymerizable conjugated double bonds per molecule preferably contains a compound having a styryl group.

When the compound having two or more polymerizable conjugated double bonds per molecule contains a compound having a styryl group, the heat resistance of the cured product is enhanced by the aromatic ring included in the styryl group.

Examples of the compound having a styryl group include divinylbenzene, 1,2-bis(vinylphenyl)ethane, 1,4-bis(vinylphenyl)butane, and modified polyphenylene ether resins having two styryl groups per molecule.

Examples of compounds having the maleimide group include bismaleimides.

The weight average molecular weight of the compound having two or more polymerizable conjugated double bonds per molecule is preferably from $1.0 \times 10^2$ to $1.0 \times 10^5$, and is more preferably from $5.0 \times 10^2$ to $5.0 \times 10^4$.

The thermosetting component contains the thermosetting resin at an amount of preferably 20 wt.% or greater, more preferably 50 wt.% or greater, even more preferably from 60 to 90 wt.%, and yet even more preferably from 70 to 80 wt.%.

In an embodiment, the thermosetting component preferably contains 20 wt.% or greater of the thermosetting resin according to the present embodiment (first embodiment) (namely, a resin having a plurality of ethylenically unsaturated groups per molecule and for which, the percentage of a number of ethylenically unsaturated groups in which both of the two carbon atoms constituting a carbon-carbon double bond of an ethylenically unsaturated group are bonded to one or two atoms other than a hydrogen atom by single bonds is 50% or greater, with proviso that a total number of ethylenically unsaturated groups is 100%). When the thermosetting component contains 20 wt.% or greater of the thermosetting resin according to the present embodiment (first embodiment), the dielectric loss tangent of the cured product of the thermosetting resin composition at a high frequency is likely to be small.

When the content thereof is 20 wt.% or greater, the content may be 30 wt.% or greater, 40 wt.% or greater, or 50 wt.% or greater. However, when the content of the thermosetting resin is 50 wt.% or greater, the dielectric loss tangent of the cured product of the thermosetting resin composition tends to be smaller at a high frequency than at a low frequency. When the thermosetting component contains the thermosetting resin at an amount of 50 wt.% or greater, the content of the thermosetting resin may be 60% or greater, 70% or greater, 80% or greater, 90% or greater, or 100%.

In an embodiment, the thermosetting component contains, as the thermosetting resin, a polyoctenylene, a styrene-butadiene-styrene block copolymer, an ethylene-propylene-diene copolymer, a polyisoprene, or a mixture of one or more thereof, at an amount of preferably 20 wt.% or greater, and more preferably 50 wt.% or greater. In an embodiment, the thermosetting resin may contain one or more selected from the group consisting of polyoctenylenes, styrene-butadiene-styrene block copolymers, ethylene-propylene-diene copolymers, and polyisoprenes at a total amount of 80 mass% or greater, or 90 mass% or greater, or may be composed of one or more selected from the group consisting of polyoctenylenes, styrene-butadiene-styrene block copolymers, ethylene-propylene-diene copolymers, and polyisoprenes.

When the thermosetting component contains a compound having two or more polymerizable conjugated double bonds per molecule in addition to the thermosetting resin, the thermosetting resin is preferably a styrene-butadiene-styrene block copolymer from the viewpoint of miscibility with the compound.

A compound containing a polyoctenylene is preferable because the dielectric loss tangent of the cured product of the thermosetting resin composition at a high frequency is likely to be small and/or the dielectric loss tangent of the cured product at a high frequency is likely to be smaller than that at a low frequency. The polyoctenylene may have a low molecular weight, and the low molecular weight polyoctenylene may be, for example, a polyoctenylene having a Mw of less than 140000, or may be a polyoctenylene having a Mw of 100000 or less, 90000 or less, 80000 or less, or 70000 or less, but is preferably a polyoctenylene having a Mw of 68000 or less. In the case of a polyoctenylene having a Mw of 68000 or less, the Mw may be 68000 or 62000.

Radical Polymerization Initiator

From the viewpoint of not worsening the dielectric loss tangent (not increasing the dielectric loss tangent) of the cured product of the thermosetting resin composition, the radical polymerization initiator is preferably a radical polymerization initiator having a tertiary butyl group or a cumyl group.

From the viewpoint of being able to cure the thermosetting resin composition at 200°C or less, the radical polymerization initiator is preferably a radical polymerization initiator having a tertiary butyl group or a cumyl group.

Examples of the radical polymerization initiator include organic peroxides.

Examples of the organic peroxides include the following compounds.

Dicumyl peroxide (trade name: for example, Percumyl E, Percumyl D-40, Percumyl D-40MT (T), etc.),
t-butylperoxy benzoate (trade name: for example, Perbutyl Z, etc.), 1,1-bis(t-butylperoxy)-3,5,5-trimethylcyclohexane,
2,5-dimethylhexane-2,5-dihydroperoxide, di-t-butyl peroxide (trade name: for example, Perbutyl D, etc.),
t-butylcumyl peroxide (trade name: for example, Perbutyl C, etc.),
α,α-bis(t-butylperoxy)-p-diisopropyl benzene,
2,5-dimethyl-2,5-di(t-butylperoxy)hexane (trade name: for example, Perhexa 25B, Perhexa 25B-40, etc.),
2,5-dimethyl-2,5-di(t-butylperoxy)-hexyne-3 (trade name: for example, Perhexyne 25B, Perhexyne 25B-40, etc.),
benzoyl peroxide,
t-butylperoxybenzene,
2,5-dimethyl-2,5-di(benzoylperoxy)hexane (trade name: for example, Perhexa 25Z, etc.),
t-butylperoxymaleic acid (trade name: for example, t-butyl MA, etc.),
t-butylperoxy isopropyl carbonate (trade name: for example, Perbutyl I-75, etc.),
methyl ethyl ketone peroxide (trade name: for example, Permec D (DR), Permec H (HR, HY), Permec N (NR, NY), Permec S (SR), Permec F (FR), Permec G (GR, GY), etc.),
cyclohexanone peroxide (trade name: for example, Perhexa H, etc.),
acetylacetone peroxide (trade name: for example, Percure AH, AL, etc.), 1,1-di(t-hexylperoxy)-3,3,5-trimethylcyclohexane (trade name: for example, Perhexa TMH, etc.),
1,1-di(t-hexylperoxy)cyclohexane(trade name: for example, Perhexa HC, etc.), 1,1-di(t-butylperoxy)-2-methylcyclohexane (trade name: for example, Perhexa MC, etc.),
1,1-di(t-butylperoxy)cyclohexane (trade name: for example, Perhexa C-80 (S), Perhexa C-75 (EB), Perhexa C (C), Perhexa C-40, Perhexa C-40MB (S), etc.),
2,2-di(t-butylperoxy)butane (trade name: for example, Perhexa 22, etc.),
butyl-4,4-di-(t-butylperoxy)valerate (trade name: for example, Perhexa V, Perhexa V-40 (F), etc.),
2,2-di(4,4-di-(t-butylperoxy)cyclohexyl)propane (trade name: for example, Pertetra A, etc.),
p-menthane hydroperoxide (trade name: for example, Permenta H, etc.),
diisopropyl benzene hydroperoxide (trade name: for example, Percumyl P, etc.),
1,1,3,3-tetramethylbutyl hydroperoxide (trade name: for example, Perocta H, etc.), cumene hydroperoxide (trade name: for example, Percumyl H-80, etc.),
t-butyl hydroperoxide (trade name: for example, Perbutyl H-69, etc.),
di(2-t-butylperoxyisopropyl)benzene (trade name: for example, Perbutyl P, Perbutyl P-40, Peroximone F-40, Perbutyl P-40MB (K), etc.),
di-t-hexylperoxide (trade name: for example, Perhexyl D, etc.),
diisobutyryl peroxide (trade name: for example, Peroyl IB, etc.),
di(3,5,5-trimethylhexanoyl)peroxide (trade name: for example, Peroyl 355 (S), etc.), dilauroyl peroxide (trade name: for example, Peroyl L, etc.),
disuccinic acid peroxide (trade name: for example, Peroyl SA, etc.), di-(3-methylbenzoyl)peroxide,
dibenzoyl peroxide (trade name: for example, Nyper BW, Nyper BO, Nyper FF, Nyper BS, Nyper E, Nyper NS, etc.),
di(4-methylbenzoyl)peroxide (trade name: for example, Nyper PMB, etc.),
di-n-propyl peroxydicarbonate (trade name: for example, Peroyl NPP-50M, etc.),
diisopropyl peroxydicarbonate (trade name: for example, Peroyl IPP-50, Peroyl IPP-27, etc.),
di(4-t-butylcyclohexyl)peroxy dicarbonate (trade name: for example, Peroyl TCP, etc.),
di(2-ethylhexyl)peroxy dicarbonate (trade name: for example, Peroyl OPP, etc.),
di-sec-butyl peroxydicarbonate (trade name: for example, Peroyl SBP, etc.),
cumyl peroxyneodecanoate (trade name: for example, Percumyl ND, Percumyl ND-50E, etc.),
1,1,3,3-tetramethylbutyl peroxyneodecanoate (trade name: for example, Perocta ND, Perocta ND-50E, etc.),
t-hexyl peroxyneodecanoate (trade name: for example, Perhexyl ND, Perhexyl ND-50E, etc.),
t-butyl peroxyneodecanoate (trade name: for example, Perbutyl ND, Perbutyl ND-50E, etc.),

t-butyl peroxyneopentanoate (trade name: for example, Perbutyl NHP, etc.),
t-hexyl peroxypivalate (trade name: for example, Perhexyl PV, Perhexyl PV-50E, etc.),
t-butyl peroxypivalate (trade name: for example, Perbutyl PV, Perbutyl PV-40E, etc.),
1,1,3,3-tetramethylbutylperoxy-2-ethylhexanoate (trade name: for example, Perocta O, etc.),
2,5-dimethyl-2,5-di(2-ethylhexanoylperoxy)hexane (trade name: for example, Perhexa 25O, etc.),
t-hexylperoxy-2-ethylhexanoate (trade name: for example, Perhexyl O, Percure HO (N), etc.),
t-butylperoxy-2-ethylhexanoate (trade name: for example, Perbutyl O, Percure O, etc.),
t-hexylperoxyisopropyl monocarbonate (trade name: for example, Perhexyl I, etc.),
t-butylperoxy-3,5,5-trimethylhexanoate (trade name: for example, Perbutyl 355, etc.),
t-butyl peroxy laurate (trade name: for example, Perbutyl L, etc.),
t-butylperoxy-2-ethylhexyl monocarbonate (trade name: for example, Perbutyl E, etc.),
t-hexyl peroxybenzoate (trade name: for example, Perhexyl Z, etc.),
t-butyl peroxyacetate (trade name: for example, Perbutyl A, etc.),
t-butyl peroxy allyl monocarbonate (trade name: for example, Peroma AC, etc.),
3,3',4,4'-tetra(t-butylperoxycarbonyl)benzophenone (trade name: for example, BTTB-25, etc.), and
2,3-dimethyl-2,3-diphenylbutane (trade name: for example, Nofmar BC-90, etc.).

The organic peroxide is preferably dicumyl peroxide or t-butyl peroxybenzoate.

Organic Solvent

Examples of the organic solvent include hydrocarbons, ethers, esters, and ketones.
Examples of the hydrocarbons include cyclic hydrocarbons and linear hydrocarbons, and more specific examples include toluene, hexane (e.g., n-hexane), pentane (e.g., n-pentane), heptane, octane, cyclohexane, decalin, and benzene.
Examples of the ethers include asymmetric ethers and symmetric ethers, and more specific examples include diisopropyl ether and diethyl ether.
Examples of the esters include ethyl acetate.
Examples of the ketones include methyl ethyl ketone, acetone, and cyclohexanone.
The solvent is preferably a hydrocarbon and is more preferably toluene.

Additives

Examples of the additives include coloring agents, fillers, plasticizers, antiaging agents, antioxidants, surfactants, and flame retardants.

Cured Product Properties

The cured product of the thermosetting resin composition exhibits excellent dielectric properties with respect to high-frequency radio waves.
Here, in the present specification, "excellent dielectric properties" means that the dielectric loss tangent of the cured product of the thermosetting resin composition at a high frequency is small, and/or the dielectric loss tangent of the cured product at a high frequency is smaller than that at a low frequency.
In an embodiment, the matter of the dielectric loss tangent of the cured product of the thermosetting resin composition at a high frequency being small preferably means that the dielectric loss tangent at 40 GHz is $8.0 \times 10^{-3}$ or less and/or an estimated value of K at 310 GHz is less than 1.54E+09.
In an embodiment, the dielectric loss tangent at 40 GHz of the cured product of the thermosetting resin composition is preferably smaller than the dielectric loss tangent at 10 GHz of the cured product.
Here, the matter of the dielectric loss tangent of the cured product of the thermosetting resin composition being smaller at 40 GHz than at 10 GHz and/or smaller at 80 GHz than at 40 GHz means, in other words, that the rate of change of the dielectric loss tangent as determined by the following equation is less than 0%.
Rate of change (%) of dielectric loss tangent = (dielectric loss tangent at 40 GHz of cured product - dielectric loss tangent at 10 GHz of cured product)/(dielectric loss tangent at 10 GHz of cured product) $\times$ 100%
The rate of change of the dielectric loss tangent is preferably -2.0% or less, and more preferably -2.5% or less.
The dielectric loss tangent at 40 GHz of the cured product of the thermosetting resin composition is preferably $8.0 \times 10^{-3}$ or less, and more preferably $5.0 \times 10^{-3}$ or less.
In an embodiment, the dielectric loss tangent at 40 GHz of the cured product of the thermosetting resin composition is preferably $8.0 \times 10^{-3}$ or less, and when $8.0 \times 10^{-3}$ or less, the dielectric loss tangent thereof may be

$7.0 \times 10^{-3}$ or less, $6.0 \times 10^{-3}$ or less, $5.0 \times 10^{-3}$ or less, $4.0 \times 10^{-3}$ or less, $3.0 \times 10^{-3}$ or less, or $20 \times 10^{-3}$ or less. A method for measuring the dielectric loss tangent will be described later.

The estimated value of K at 310 GHz of the cured product of the thermosetting resin composition is preferably less than 1.54E+09, and more preferably 1.00E+09 or less. When 1.00E+09 or less, the estimated value of K thereof may be 8.00E+08 or less, 5.00E+08 or less, 3.00E+08 or less, 1.00E+08 or less, 8.00E+07 or less, 5.00E+07 or less, or 3.00E+07 or less. Note that the descriptions of "1.00E+09" or the like mean " $1.00 \times 10^9$" or the like. A method of calculating the estimated value of K at 310 GHz will be described later.

Cured Product

The cured product of the thermosetting resin composition is obtained by sufficiently subjecting the thermosetting resin composition to a curing reaction by heating.

In order to sufficiently cure the thermosetting resin composition by heating, the thermosetting resin composition is heat-pressed, for example.

The conditions for curing the thermosetting resin composition are not particularly limited as long as the thermosetting resin composition undergoes a sufficient curing reaction, and the curing conditions may be appropriately set according to the formulation constituting the thermosetting resin composition.

Measurement of Dielectric Loss Tangent

The dielectric loss tangent can be determined as follows.

In accordance with the method described in JIS R 1641-2007 ["Measurement method for dielectric of fine ceramic plates at microwave frequency", the room temperature is set to 23±2°C, the relative humidity is set to 50±5%, the radio wave frequency is set to 10 GHz or 40 GHz, and the dielectric loss tangent of the cured product is measured three times.

The arithmetic mean value of the measured values is then taken as the dielectric loss tangent of the cured product.

The measurement conditions can be, for example, as follows.

Measurement device: vector network analyzer (model number: MS46122B, available from Anritsu Corporation)
Cured product: film-shaped cured product (thickness: for example, 100 μm)

Estimated Value of K at 310 GHz

The estimated value of K at 310 GHz can be determined as follows.

K = frequency × (dielectric constant (at 310 GHz) to the 0.5th power) × (dielectric loss tangent (at 310 GHz))

The dielectric constant (at 310 GHz) can be calculated assuming that the dielectric constant changes up to 310 GHz at the same rate of change as the rate of change of the dielectric constant from 10 GHz to 40 GHz.

In addition, the dielectric loss tangent (at 310 GHz) can be calculated with the assumption that the dielectric loss tangent changes up to 310 GHz at the same rate of change as the rate of change of the dielectric loss tangent from 10 GHz to 40 GHz.

Evaluation of Heat Resistance

The heat resistance of the cured product of the thermosetting resin composition can be evaluated as follows.

The heat resistance of the cured product can be evaluated using a dynamic mechanical analyzer (DMA) in accordance with JIS K7244-4:1999 "Plastics - Determination of dynamic mechanical properties - Part 4: Tensile vibration - Nonresonance method".

First, a film-shaped cured product measuring 3 mm × 20 mm × 0.1 mm is prepared, and then the film-shaped cured product is fixed to a tensile vibration jig of the dynamic mechanical analyzer (DMA). Then, the storage elastic modulus E' at each temperature is measured by the dynamic mechanical analyzer (DMA) while a stress is applied under the following conditions to the film-shaped cured product that is fixed to the tensile vibration jig.

The measurement conditions can be set as follows.

Measurement temperature range: from 0°C to 250°C
Rate of temperature increase: 5°C/min

Frequency: 10 Hz
Strain: 0.5%

Subsequently, the rate of change of E' is determined by the following equation.

Rate of Change (%) of E' = (E' at 200°C - E' at 210°C) ÷ (E' at 200°C) × 100%

The heat resistance of the cured product can be evaluated on the basis of the following criteria.

◦: The absolute value of the rate of change of E' is less than 10%.
×: The absolute value of the rate of change of E' is 10% or greater.

Resin Composition for Printed Wiring Board

The resin composition for a printed wiring board according to the present embodiment is the above-described thermosetting resin composition and is used for manufacturing a printed wiring board.
In an embodiment, the thermosetting resin composition according to the first embodiment can be used as a resin composition for a printed wiring board.
In an embodiment, a cured product of the thermosetting resin composition has a property of excelling in dielectric properties with regards to high-frequency radio waves, and therefore the thermosetting resin composition can be preferably used for producing a structural portion of a printed wiring board where an electrically insulating material is desired.
The printed wiring board is, for example, a laminate in which a substrate and a pattern film are laminated.
Here, in a general structure of a printed wiring board (also referred to as a printed circuit board), a semiconductor package (in which an electronic component such as a semiconductor chip is mounted on a base called a substrate) is mounted on a printed circuit board (PCB). The "substrate" in the present specification includes a printed circuit board.
In addition, the pattern film in the present specification refers to one or more layers in the structure of the printed wiring board with at least some of the one or more layers including a wiring pattern, and the pattern film may include, in addition to the layers in which the wiring pattern is directly disposed, one or more layers such as an interlayer insulating film layer. Since a cured product of the thermosetting resin composition has a property of excelling in dielectric properties with regards to high-frequency radio waves, the thermosetting resin composition can be preferably used for producing a structural portion in which an electrically insulating material is desired, even among the one or more layers including the wiring pattern.
One example of a method in which the thermosetting resin composition is used as a resin composition for a printed wiring board is a method in which a fibrous base material is immersed in a varnish containing the thermosetting resin composition and an organic solvent and then dried to prepare a prepreg, after which a metal foil is layered on the prepreg, and the metal-layered prepreg is press-molded with heating and pressurization to thereby prepare a metal-clad laminated plate.
The resin composition for a printed wiring board according to the present embodiment may be used for preparing the substrate or may be used for preparing the pattern film.
The resin composition for a printed wiring board substrate according to the present embodiment is the above-described thermosetting resin composition and is used for producing the abovementioned substrate.
In an embodiment, the thermosetting resin composition according to the first embodiment can be used for producing a substrate of a printed wiring board.
In an embodiment, the thermosetting resin composition according to the first embodiment can be used for producing a pattern film of a printed wiring board.
The printed wiring board according to an embodiment is a printed wiring board in which a pattern film and a substrate including a cured product of the thermosetting resin composition according to the first embodiment are laminated.
The printed wiring board according to an embodiment is a printed wiring board in which a substrate and a pattern film including a cured product of the thermosetting resin composition according to the first embodiment are laminated.
The thermosetting resin composition, the resin composition for a printed wiring board, and the resin composition for a printed wiring board substrate according to the present embodiment are configured as described above, and thus have the following advantages.
As a result of intensive studies, the present inventors discovered that when a thermosetting resin composition contains a specific thermosetting resin, a cured product of the thermosetting resin composition tends to have a lower dielectric loss tangent as the frequency of radio waves increases.

In addition, as a result of further intensive studies, the present inventors discovered that a cured product in which the dielectric loss tangent decreases as the frequency of radio waves increases has excellent dielectric properties with respect to high-frequency radio waves, and thereby the present inventors arrived at the present embodiment.
That is, the thermosetting resin composition according to the first embodiment contains a thermosetting resin.
The thermosetting resin has a plurality of ethylenically unsaturated groups per molecule.
Each of the ethylenically unsaturated groups is a carbon-carbon double bond containing two carbon atoms.
A ratio of a number of ethylenically unsaturated groups in which both of the two carbon atoms are bonded to one or two atoms other than a hydrogen atom by single bonds is 50% or greater, with proviso that a total number of the ethylenically unsaturated groups of the thermosetting resin composition is 100%.
The dielectric loss tangent at 40 GHz of a cured product of the thermosetting resin composition is smaller than the dielectric loss tangent at 10 GHz of the cured product.
According to the present embodiment, a thermosetting resin composition from which is obtained a cured product that excels in dielectric properties with respect to high-frequency radio waves can be provided.
Note that various modifications can be made to the thermosetting resin composition, the resin composition for a printed wiring board, and the resin composition for a printed wiring board substrate of the present disclosure, without departing from the gist of the present disclosure.

Second Embodiment

Thermosetting Resin Composition

The thermosetting resin composition according to the present embodiment includes a thermosetting component containing a thermosetting resin.
The thermosetting resin has a plurality of ethylenically unsaturated groups per molecule.
The thermosetting resin composition is configured such that a ratio of a number of ethylenically unsaturated groups in which both of the two carbon atoms constituting a carbon-carbon double bond of an ethylenically unsaturated group are bonded to one or two atoms other than a hydrogen atom by single bonds is 50% or greater, with proviso that a total number of ethylenically unsaturated groups is 100%.
In an embodiment, the thermosetting resin composition according to the present embodiment preferably further contains a radical polymerization initiator.
In an embodiment, the thermosetting resin composition according to the present embodiment may further contain an additive.
In an embodiment, the thermosetting resin composition according to the present embodiment may further contain an organic solvent that dissolves the thermosetting component.
The thermosetting resin composition according to the present embodiment may be in a liquid form, with an organic solvent contained.
The thermosetting resin composition according to the present embodiment may also be in a solid form.

Thermosetting Component

The "thermosetting component" in the second embodiment is as described in the first embodiment.

Compound Having Two or More Polymerizable Conjugated Double Bonds Per Molecule

The "compound having two or more polymerizable conjugated double bonds per molecule" in the second embodiment is as described in the first embodiment.

Radical Polymerization Initiator

The "radical polymerization initiator" in the second embodiment is as described in the first embodiment.

Organic Solvent

The "organic solvent" in the second embodiment is as described in the first embodiment.

Additives

The "additives" in the second embodiment are as described in the first embodiment.

In the second embodiment, the "cured product properties", the "cured product", the "measurement of dielectric loss tangent", the "estimated value of K at 310 GHz", and the "evaluation of heat resistance" are as described in the first embodiment.

Resin Composition for Printed Wiring Board

The resin composition for a printed wiring board according to the second embodiment is the thermosetting resin composition according to the second embodiment, and is used for manufacturing a printed wiring board. The printed wiring board is as described in the first embodiment.
In an embodiment, the thermosetting resin composition according to the second embodiment can be used as a resin composition for a printed wiring board.
The resin composition for a printed wiring board according to an embodiment includes the thermosetting resin composition according to the second embodiment.
In an embodiment, the thermosetting resin composition according to the second embodiment can be used for producing a substrate of a printed wiring board.
In an embodiment, the thermosetting resin composition according to the second embodiment can be used for producing a pattern film of a printed wiring board.
The printed wiring board according to an embodiment is a printed wiring board in which a pattern film and a substrate including a cured product of the thermosetting resin composition according to the second embodiment are laminated.
The printed wiring board according to an embodiment is a printed wiring board in which a substrate and a pattern film including a cured product of the thermosetting resin composition according to the second embodiment are laminated.
In the second embodiment, the thermosetting resin composition includes a thermosetting component containing a thermosetting resin, the thermosetting resin has a plurality of ethylenically unsaturated groups per molecule, and a ratio of a number of ethylenically unsaturated groups in which both of the two carbon atoms constituting a carbon-carbon double bond of an ethylenically unsaturated group are bonded to one or two atoms other than a hydrogen atom by single bonds is 50% or greater, with proviso that a total number of ethylenically unsaturated groups is 100%.
In the thermosetting resin composition, the thermosetting component preferably contains a thermosetting resin at an amount of 20 wt.% or greater,

in the thermosetting resin composition, a trans-conformation percentage of the thermosetting resin contained in the thermosetting component is preferably 30% or greater,
the thermosetting component preferably includes one or more thermosetting resins selected from the group consisting of polyoctenylenes, styrene-butadiene-styrene block copolymers, and ethylene-propylene-diene copolymers, and/or
the thermosetting resin preferably contains substantially no epoxy groups.

With such a thermosetting resin composition according to the second embodiment, a dielectric loss tangent of a cured product of the thermosetting resin composition at a high frequency tends to be small, and/or a dielectric loss tangent of the cured product at a high frequency tends to be smaller than that at a low frequency.
In the thermosetting resin composition according to the second embodiment, the thermosetting component more preferably further contains, in addition to the thermosetting resin, a compound having two or more polymerizable conjugated double bonds per molecule.
Such a thermosetting resin composition according to the second embodiment also has excellent heat resistance.

Examples

Next, the present disclosure will be described more specifically with reference to examples and comparative examples. Note that the present disclosure is not to be considered limited to these examples at all.

Materials

The following materials were prepared as materials for the thermosetting resin compositions of the examples and comparative examples.
Thermosetting Resin (hereinafter, also referred to as "First Thermosetting Component") configured such that percentage of number of ethylenically unsaturated groups in which both of the two carbon atoms included in ethylenically unsaturated group are bonded to one or two atoms other than hydrogen atom by single bonds is 50% or greater (hereinafter, percentage thereof is also simply referred to as "Predetermined Percentage of Number of Ethylenically

Unsaturated Groups"), with proviso that total number of ethylenically unsaturated groups was 100%

Polyoctenylene (Vestenamer (trade name) (weight average molecular weight: approximately 140000) available from Daicel-Evonik Ltd.) (predetermined percentage of the number of ethylenically unsaturated groups: 100%)
Polyoctenylene (weight average molecular weight: 68000, predetermined percentage of the number of ethylenically unsaturated groups: 100%)
Polyoctenylene (weight average molecular weight: 16000, predetermined percentage of the number of ethylenically unsaturated groups: 100%)
Polyoctenylene (weight average molecular weight: 6200, predetermined percentage of the number of ethylenically unsaturated groups: 100%)
Styrene-butadiene-styrene block copolymer (polystyrene-block-polybutadiene-block-polystyrene available from Sigma-Aldrich Co., Ltd., product number: 432490) (content percentage of styrene as a constituent unit: 30 wt.%) (hereinafter, also referred to as "SBS") (predetermined percentage of the number of ethylenically unsaturated groups: 90%)
Ethylene-propylene-diene copolymer (predetermined percentage of the number of ethylenically unsaturated groups: 100%)
Polyisoprene (trans-1,4-polyisoprene, weight average molecular weight: 250000, predetermined percentage of the number of ethylenically unsaturated groups: 100%, available from Sigma-Aldrich Co., Ltd., product number: 182168)

(Compound having two or more polymerizable conjugated double bonds per molecule (hereinafter, also referred to as a "second thermosetting component"))

Modified polyphenylene ether resin having two styryl groups per molecule (hereinafter, also simply referred to as "modified PPE") (OPE-St1200 available from Mitsubishi Gas Chemical Co., Inc.)
1,2-bis(vinylphenyl)ethane (BVPE available from Dainichi Chemical Co., Ltd.)

Polyoctenylenes having weight average molecular weights (Mw) of 68000, 16000, and 62000 were prepared using a molecular weight regulator in accordance with the method described in WO 2011/160916.

Radical Polymerization Initiator

t-butyl peroxybenzoate (Perbutyl Z available from NOF Corporation)
Dicumyl peroxide (Percumyl D available from NOF Corporation)

Organic Solvent

Toluene

Other

Hydrogenated styrene-butadiene-styrene block copolymer (RICON 100 available from Cray Valley SA) (hereinafter, also referred to as a "first hydrogenated SBS") (predetermined percentage of the number of ethylenically unsaturated groups: 30%)

Hydrogenated styrene-butadiene-styrene block copolymer (SEPTON 8007L available from Kuraray Co., Ltd.) (hereinafter, also referred to as a "second hydrogenated SBS") (predetermined percentage of the number of ethylenically unsaturated groups: 0%)
Styrene-isoprene-styrene block copolymer (hereinafter, also referred to as "SIS") (Hybrar 5127 available from Kuraray Co., Ltd.) (predetermined percentage of the number of ethylenically unsaturated groups: 0%)
Hydrogenated polyoctenylene (weight average molecular weight: 140000, hydrogenation rate: 99% or greater, produced by hydrogenating polyoctenylene (Mw 140000) in accordance with JP 4456478 B. predetermined percentage of the number of ethylenically unsaturated groups: 0%)
Polyethylene (PE) (predetermined percentage of the number of ethylenically unsaturated groups: 0%, available from Sigma-Aldrich Co., Ltd., product number: 428043)

Example 1

The above materials were mixed at the proportions shown in the following Table 1 to produce a first mixed solution as a thermosetting resin composition.
Next, the mixed solution was stirred at 50°C to sufficiently dissolve the components other than toluene in the toluene, and thereby a second mixed solution was produced.
The second mixed solution was then coated onto a Teflon (trade name) sheet to produce a coated material on the Teflon sheet.
Subsequently, the coated material was allowed to stand overnight at room temperature to evaporate the toluene, and thereby a film-shaped mixture was produced on the Teflon sheet.
Next, the film-shaped mixture was pulverized to produce a pulverized product, which was a thermosetting resin composition.
The pulverized product was then inserted into a mold having a recess with a depth of 100 μm.
Subsequently, the mold was set in a vacuum press machine, and while the pulverized product was heated at 200°C in a vacuum state, a pressure of 0.5 MPa (gauge pressure) was applied for 2 hours, and thereby a film-shaped cured product (thickness: 100 μm) was obtained.

Examples 2 to 8 and 10 to 15

Thermosetting resin compositions were produced in the same manner as in Example 1 with the exception that the materials were mixed at the proportions described in Table 1 below.
Film-shaped cured products were then produced from the thermosetting resin compositions in the same manner as in Example 1.

Example 9 and Comparative Examples 2 to 5

Thermosetting resin compositions were produced in the same manner as in Example 1 with the exception that the materials were mixed at the proportions described in Table 1 below.
Film-shaped cured products were then produced from the thermosetting resin compositions in the same manner as in Example 1 with the exception that the temperature for heating the pulverized product was set to 120°C.

Comparative Example 1

A thermosetting resin composition was produced in the same manner as in Example 1 with the exception that the materials were mixed at the ratios described in Table 1 below.
A film-shaped cured product was produced from the thermosetting resin composition in the same manner as in Example 1 with the exception that the pulverized product was pressurized at a pressure of 0.1 MPa.

Measurement of Dielectric Constant and Dielectric Loss Tangent of Cured Product

The relative dielectric constant (hereinafter, also simply referred to as the "dielectric constant") and the dielectric loss tangent of the cured product at 10 GHz and at 40 GHz were measured.
Note that the "dielectric constant of the cured product at 10 GHz" is also described as the "dielectric constant (10 GHz)". Similarly, the "dielectric constant of the cured product at 40 GHz" is also described as the "dielectric constant (40 GHz)". Furthermore, the "dielectric loss tangent of the cured product at 10 GHz" is also described as the "dielectric loss tangent (10 GHz)". Similarly, the "dielectric loss tangent of the cured product at 40 GHz" is also described as the "dielectric loss tangent (40 GHz)".
The dielectric loss tangent was measured by the method described above. The dielectric constant was also measured by a method similar to that of the dielectric loss tangent.
In addition, the values of "dielectric constant (40 GHz) - dielectric constant (10 GHz)" and "dielectric loss tangent (40 GHz) - dielectric loss tangent (10 GHz)" were determined.
The rate of change of the dielectric constant and the rate of change of the dielectric loss tangent were then determined.
The rate of change of the dielectric loss tangent was determined by the method described above.
In addition, the rate of change of the dielectric constant was determined by the following equation.
Dielectric constant rate of change (%) = (dielectric constant of the cured product at 40 GHz - dielectric constant of the cured product at 10 GHz)/(dielectric constant of the cured product at 10 GHz) × 100
These values are shown in Table 1 below.

Dielectric Property Evaluation

It is known that transmission loss is proportional to the following K.

$$K = \text{frequency} \times (\text{dielectric constant to the 0.5th power}) \times (\text{dielectric loss tangent})$$

Therefore, the following K at a frequency of 310 GHz was determined.

K = 310 GHz × (dielectric constant (310 GHz) to the 0.5th power) × (dielectric loss tangent (310 GHz))

Here, "dielectric constant (310 GHz)" means the "dielectric constant of the cured product at 310 GHz".
Moreover, "dielectric loss tangent (310 GHz)" means the "dielectric loss tangent of the cured product at 310 GHz" .
Also, the dielectric constant and the dielectric loss tangent could not be measured with radio waves having a high frequency of 310 GHz.
Therefore, estimated values were used as the dielectric constant (310 GHz) and the dielectric loss tangent (310 GHz).
The dielectric constant (310 GHz) was calculated on the assumption that the dielectric constant changes up to 310 GHz at the same rate of change as the rate of change of the dielectric constant from 10 GHz to 40 GHz.
In addition, the dielectric loss tangent (310 GHz) was calculated on the assumption that the dielectric loss tangent changes up to 310 GHz at the same rate of change as the rate of change of the dielectric loss tangent from the 10 GHz to 40 GHz.
These values are shown in Table 1 below.

Evaluation of Heat Resistance

The heat resistance of the cured product was evaluated using a dynamic mechanical analyzer (DMA) in accordance with JIS K7244-4:1999 "Plastics - Determination of dynamic mechanical properties - Part 4: Tensile vibration - Nonresonance method".
First, a film-shaped cured product measuring 3 mm × 20 mm × 0.1 mm was prepared.
Next, the film-shaped cured product was fixed to a tensile vibration jig of a dynamic mechanical analyzer (DMA).
Then, the storage elastic modulus E' at each temperature was measured by the dynamic mechanical analyzer (DMA) while a stress was applied under the following conditions to the film-shaped cured product that was fixed to the tensile vibration jig.

Measurement temperature range: from 0°C to 250°C
Rate of temperature increase: 5°C/min
Frequency: 10 Hz
Strain: 0.5%
Subsequently, the rate of change of E' was determined by the following equation.

$$\text{Rate of Change (\%) of } E' = (E' \text{ at } 200°C - E' \text{ at } 210°C) \div (E' \text{ at } 200°C) \times 100\%$$

Furthermore, the heat resistance of the cured product was evaluated using the following criteria.

◦: The absolute value of the rate of change of E' is less than 10%.
×: The absolute value of the rate of change of E' is 10% or greater.

The results are shown in Table 1 below.

Table 1

| | | | Trans-conformation percentage (%) | Average number of trans double bonds per molecule | Example 1 | Example 2 | Example 3 | Example 4 | Example 5 | Example 6 | Example 7 | Example 8 | Example 9 | Example 10 |
|---|---|---|---|---|---|---|---|---|---|---|---|---|---|---|
| Blending proportion (parts by weight) of thermosetting resin composition | First thermosetting component | Polyoctenylene (Mw 140000) | 82 | 413 | 1.00 | 0.80 | 0.70 | 0.80 | 0.50 | | | | | 0.50 |
| | | Low molecular weight polyoctenylene (1) (Mw 68000) | 64 | 156 | | | | | | | | | | |
| | | Low molecular weight polyoctenylene (2) (Mw 16000) | 62 | 35 | | | | | | | | | | |
| | | Low molecular weight polyoctenylene (3) (Mw 6200) | 39 | 8 | | | | | | | | | | |
| | | SBS | 37 | 259 | | | | | | 1.00 | 0.80 | 0.50 | | |
| | | Ethylene-propylene-diene copolymer | 0 | 0 | | | | | | | | | 1.00 | |
| | | Trans-1,4-polyisoprene | 99 | 700 | | | | | | | | | | |
| | Other | First hydrogenated SBS | - | | | | | | | | | | | |
| | | Second hydrogenated SBS | - | | | | | | | | | | | |
| | | SIS | - | | | | | | | | | | | |
| | | Hydrogenated polyoctenylene | 0 | | | | | | | | | | | |
| | | PE | 0 | | | | | | | | | | | |
| | Second thermosetting component | Modified PPE | - | | | 0.20 | 0.30 | | | | 0.20 | 0.50 | | 0.50 |
| | | 1,2-bis(vinylphenyl)ethane | - | | | | | 0.20 | 0.50 | | | | | |
| | Radical polymerization initiator | t-butyl peroxybenzoate | - | | | | | | | | | | | |
| | | Dicumyl peroxide | - | | 0.02 | 0.02 | 0.02 | | | | | | | |
| | Solvent | Toluene | - | | 4.00 | 4.00 | 4.00 | 4.00 | 4.00 | 4.00 | 4.00 | 4.00 | 4.00 | 4.00 |
| Physical properties of cured product | Dielectric constant (10 GHz) (-) | | | | 2.357 | 2.307 | 2.481 | 2.285 | 2.687 | 2.302 | 2.435 | 2.475 | 2.258 | 2.495 |
| | Dielectric loss tangent (10 GHz) (-) | | | | 0.00218 | 0.00250 | 0.00287 | 0.00162 | 0.00142 | 0.00266 | 0.00256 | 0.00491 | 0.00034 | 0.00262 |
| | Dielectric constant (40 GHz) (-) | | | | 2.338 | 2.397 | 2.411 | 2.295 | 2.616 | 2.333 | 2.472 | 2.554 | 2.278 | 2.397 |
| | Dielectric loss tangent (40 GHz) (-) | | | | 0.00175 | 0.00218 | 0.00279 | 0.00140 | 0.00133 | 0.00211 | 0.00223 | 0.00404 | 0.00029 | 0.00255 |
| | Dielectric constant (40 GHz) - dielectric constant (10 GHz) (-) | | | | -0.018 | 0.090 | -0.070 | 0.010 | -0.071 | 0.031 | 0.037 | 0.079 | 0.020 | -0.098 |
| | Dielectric loss tangent (40 GHz) - dielectric loss tangent (10 GHz) (-) | | | | -0.00043 | -0.00032 | -0.00008 | -0.00022 | -0.00008 | -0.00055 | -0.00033 | -0.00086 | -0.00004 | -0.00007 |
| | Rate of change (%) of dielectric constant | | | | -0.78 | 3.90 | -2.82 | 0.43 | -2.64 | 1.34 | 1.53 | 3.18 | 0.90 | -3.94 |
| | Rate of change (%) of dielectric loss tangent | | | | -19.87 | -12.80 | -2.83 | -13.38 | -5.88 | -20.52 | -12.99 | -17.58 | -12.91 | -2.67 |
| Calculated dielectric constant (310 GHz) (-) | | | | | 2.179 | 3.383 | 1.863 | 2.386 | 2.055 | 2.631 | 2.835 | 3.385 | 2.470 | 1.670 |
| Calculated dielectric loss tangent (310 GHz) (-) | | | | | 0.00024 | 0.00064 | 0.00215 | 0.00039 | 0.00077 | 0.00027 | 0.00064 | 0.00071 | 0.00008 | 0.002 |
| Evaluation | K (GHz) | | | | 1.09E+08 | 3.62E+08 | 9.11E+08 | 1.85E+08 | 3.43E+08 | 1.35E+08 | 3.32E+08 | 4.05E+08 | 4.10E+07 | 8.01E+08 |
| | Heat resistance | | | | × | ○ | ○ | ○ | ○ | × | ○ | ○ | × | ○ |

| | | | Example 11 | Example 12 | Example 13 | Example 14 | Example 15 | Comparative Example 1 | Comparative Example 2 | Comparative Example 3 | Comparative Example 4 | Comparative Example 5 |
|---|---|---|---|---|---|---|---|---|---|---|---|---|
| Blending proportion (parts by weight) of thermosetting resin composition | First thermosetting component | Polyoctenylene (Mw 140000) | 0.5 | 0.5 | 0.5 | 0.20 | | | | | | |
| | | Low molecular weight polyoctenylene (1) (Mw 68000) | 0.5 | | | | | | | | | |
| | | Low molecular weight polyoctenylene (2) (Mw 16000) | | 0.5 | | | | | | | | |
| | | Low molecular weight polyoctenylene (3) (Mw 6200) | | | 0.5 | | | | | | | |
| | | SBS | | | | | | | | | | |
| | | Ethylene-propylene-diene copolymer | | | | | | | | | | |
| | | Trans-1,4-polyisoprene | | | | | 1.00 | | | | | |
| | Other | First hydrogenated SBS | | | | | | 1.00 | | | | |
| | | Second hydrogenated SBS | | | | | | | 1.00 | | | |
| | | SIS | | | | | | | | 1.00 | | |
| | | Hydrogenated polyoctenylene | | | | | | | | | 1.00 | |
| | | PE | | | | | | | | | | 1.00 |
| | Second thermosetting component | Modified PPE | | | | | | | | | | |
| | | 1,2-bis(vinylphenyl)ethane | | | | 0.80 | | | | | | |
| | Radical polymerization initiator | t-butyl peroxybenzoate | | | | | | 0.02 | | | | |
| | | Dicumyl peroxide | | | | | | | | | | |
| | Solvent | Toluene | 4.00 | 4.00 | 4.00 | 4.00 | 4.00 | 4.00 | 4.00 | 4.00 | 0.00 | 0.00 |
| Physical properties of cured product | | Dielectric constant (10 GHz) (-) | 2.25 | 2.22 | 2.27 | 2.383 | 2.44 | 2.606 | 2.351 | 2.265 | 2.22 | 2.48 |
| | | Dielectric loss tangent (10 GHz) (-) | 0.002 | 0.0021 | 0.0027 | 0.00096 | 0.0027 | 0.00195 | 0.00039 | 0.00112 | 0.000389 | 0.000093 |
| | | Dielectric constant (40 GHz) (-) | 2.32 | 2.27 | 2.27 | 2.354 | 2.51 | 2.562 | 2.329 | 2.293 | 2.29 | 2.35 |
| | | Dielectric loss tangent (40 GHz) (-) | 0.0015 | 0.0015 | 0.0018 | 0.00105 | 0.0022 | 0.00221 | 0.00052 | 0.00124 | 0.00045 | 0.00013 |
| | | Dielectric constant (40 GHz) - dielectric constant (10 GHz) (-) | 0.07 | 0.05 | 0 | -0.029 | 0.07 | -0.044 | -0.021 | 0.029 | 0.07 | -0.13 |
| | | Dielectric loss tangent (40 GHz) - dielectric loss tangent (10 GHz) (-) | -0.0005 | -0.0006 | -0.0009 | 0.00009 | -0.0005 | 0.00026 | 0.00012 | 0.00012 | 0.000061 | 0.000037 |
| | | Rate of change (%) of dielectric constant | 3.11 | 2.25 | 0.00 | -1.23 | 2.87 | -1.69 | -0.91 | 1.26 | 3.15 | -5.24 |
| | | Rate of change (%) of dielectric loss tangent | -25.00 | -28.57 | -33.33 | 9.73 | -18.52 | 13.59 | 31.24 | 10.68 | 15.68 | 39.78 |
| Calculated dielectric constant (310 GHz) (-) | | | 3.057 | 2.774 | 2.270 | 2.106 | 3.238 | 2.197 | 2.145 | 2.567 | 3.028 | 1.447 |
| Calculated dielectric loss tangent (310 GHz) (-) | | | 0.00011 | 0.00007 | 0.00005 | 0.00243 | 0.00035 | 0.00697 | 0.00595 | 0.00310 | 0.00167 | 0.00265 |
| Evaluation | | K (GHz) | 6.10E+07 | 3.75E+07 | 2.19E+07 | 1.09E+09 | 1.94E+08 | 3.20E+09 | 2.70E+09 | 1.54E+09 | 9.01E+08 | 9.88E+08 |
| | | Heat resistance | × | × | × | ○ | × | × | × | × | × | × |

As shown in Table 1, in Comparative Examples 1 to 5, the dielectric loss tangent at 40 GHz of the cured product of the thermosetting resin composition was larger than the dielectric loss tangent of the cured product at 10 GHz.

In Examples 1 to 15, which are within the scope of the present disclosure, K, which is proportional to the transmission loss, was smaller than in Comparative Examples 1 to 5 in which the dielectric loss tangent at 40 GHz of the cured product of the thermosetting resin composition was greater than the dielectric loss tangent at 10 GHz of the cured product.

Furthermore, in Examples 1 to 13 and 15, unlike Comparative Examples 1 to 3, the dielectric loss tangent at 40 GHz of the cured product of the thermosetting resin composition was smaller than the dielectric loss tangent at 10 GHz of the cured product.

Therefore, it is clear that according to the present disclosure, a thermosetting resin composition can be provided

from which can be obtained a cured product that excels in dielectric properties with respect to high-frequency radio waves.

In addition, as shown in Table 1, in Examples 2, 3, 4, 5, 7, 8, and 10 in which the thermosetting resin composition contained a compound having two or more polymerizable conjugated double bonds per molecule, the evaluation of the heat resistance was " o" .

Accordingly, it is understood that when the thermosetting resin composition contains a compound having two or more polymerizable conjugated double bonds per molecule, the heat resistance of the cured product is favorable.

Industrial Applicability

According to the present disclosure, a thermosetting resin composition, a resin composition for a printed wiring board, and a resin composition for a printed wiring board substrate, by which can be obtained a cured product having excellent dielectric properties with regard to high-frequency radio waves, can be provided.

## Claims

**1.** A thermosetting resin composition comprising:

a thermosetting component containing a thermosetting resin, the thermosetting resin comprising a plurality of ethylenically unsaturated groups per molecule,
wherein a percentage of a number of ethylenically unsaturated groups in which both of two carbon atoms constituting a carbon-carbon double bond of an ethylenically unsaturated group are bonded to one or two atoms other than a hydrogen atom by single bonds is 50% or greater, with proviso that a total number of ethylenically unsaturated groups of the thermosetting resin composition is 100%.

**2.** The thermosetting resin composition according to claim 1, wherein the thermosetting component contains the thermosetting resin at an amount of 20 wt.% or greater.

**3.** The thermosetting resin composition according to claim 1 or 2, wherein a trans-conformation percentage of the thermosetting resin is 30% or greater.

**4.** The thermosetting resin composition according to any one of claims 1 to 3, wherein the thermosetting resin contains one or more resins selected from the group consisting of polyoctenylenes, styrene-butadiene-styrene block copolymers, and ethylene-propylene-diene copolymers.

**5.** The thermosetting resin composition according to claim 4, wherein the thermosetting resin contains a polyoctenylene.

**6.** The thermosetting resin composition according to claim 4, wherein the thermosetting resin contains a styrene-butadiene-styrene block copolymer.

**7.** The thermosetting resin composition according to claim 4, wherein the thermosetting resin contains an ethylene-propylene-diene copolymer.

**8.** The thermosetting resin composition according to claim 3, wherein the thermosetting resin contains a polyisoprene.

**9.** The thermosetting resin composition according to any one of claims 1 to 8, wherein the thermosetting component further contains a compound having two or more polymerizable conjugated double bonds per molecule.

**10.** The thermosetting resin composition according to claim 9, wherein the compound having two or more polymerizable conjugated double bonds per molecule contains a compound having a styryl group.

**11.** The thermosetting resin composition according to claim 10, wherein the compound having a styryl group contains one or more compounds selected from the group consisting of divinylbenzene, 1,2-bis(vinylphenyl)ethane, 1,4-bis(vinylphenyl)butane, and modified polyphenylene ether resins having two styryl groups per molecule.

**12.** The thermosetting resin composition according to any one of claims 1 to 10, wherein a cured product of the thermosetting resin composition has a dielectric loss tangent at 40 GHz of $8.0 \times 10^{-3}$ or less.

**13.** The thermosetting resin composition according to any one of claims 1 to 12, wherein the dielectric loss tangent at 40 GHz of the cured product of the thermosetting resin composition is smaller than a dielectric loss tangent at 10 GHz of the cured product.

**14.** The thermosetting resin composition according to any one of claims 1 to 13, wherein the one or two atoms other than a hydrogen atom are carbon atoms.

**15.** The thermosetting resin composition according to any one of claims 1 to 14, wherein the thermosetting resin is substantially free of an epoxy group.

**16.** The thermosetting resin composition according to any one of claims 1 to 15, wherein the thermosetting resin composition further contains a radical polymerization initiator.

**17.** A resin composition for a printed wiring board, the resin composition comprising the thermosetting resin composition described in any one of claims 1 to 16.

**18.** A printed wiring board comprising:

a substrate containing a cured product of the thermosetting resin composition described in any one of claims 1 to 16; and
a pattern film,
wherein
the substrate and the pattern film are laminated.

**INTERNATIONAL SEARCH REPORT**

International application No. **PCT/JP2023/003007**

**A. CLASSIFICATION OF SUBJECT MATTER**

***C08L 101/00***(2006.01)i; ***H05K 1/03***(2006.01)i
FI: C08L101/00; H05K1/03 610H

According to International Patent Classification (IPC) or to both national classification and IPC

**B. FIELDS SEARCHED**

Minimum documentation searched (classification system followed by classification symbols)

C08L101/00; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2021/166847 A1 (PANASONIC IP MAN CO LTD) 26 August 2021 (2021-08-26) claims, examples | 1-2, 4, 7, 9-18 |
| A | | 3, 5-6, 8 |
| X | WO 2019/026927 A1 (PANASONIC IP MAN CO LTD) 07 February 2019 (2019-02-07) claims, examples | 1-2, 4, 7, 12-18 |
| A | | 3, 5-6, 8-11 |
| X | JP 2016-529205 A (ALBEMARLE CORPORATION) 23 September 2016 (2016-09-23) paragraph [0053], examples | 1-2, 4, 6-7, 12-18 |
| A | | 3, 5, 8-11 |
| X | JP 63-145325 A (DAISERU HIYURUSU KK) 17 June 1988 (1988-06-17) claims, examples | 1-5, 14-16 |
| A | | 6-13, 17-18 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 April 2023** | **18 April 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

INTERNATIONAL SEARCH REPORT

International application No.
PCT/JP2023/003007

C. DOCUMENTS CONSIDERED TO BE RELEVANT

| Category* | Citation of document, with indication, where appropriate, of the relevant passages | Relevant to claim No. |
|---|---|---|
| X<br>A | US 2016/0289429 A1 (KRATON POLYMERS U.S. LLC) 06 October 2016 (2016-10-06)<br>claims, examples | 1-5, 7-8, 14-16<br>6, 9-13, 17-18 |

Form PCT/ISA/210 (second sheet) (January 2015)

**INTERNATIONAL SEARCH REPORT**
**Information on patent family members**

International application No.
**PCT/JP2023/003007**

| Patent document cited in search report | Publication date (day/month/year) | Patent family member(s) | Publication date (day/month/year) |
|---|---|---|---|
| WO 2021/166847 A1 | 26 August 2021 | DE 112021000341 T5<br>CN 115135715 A<br>AT 524991 A2 | |
| WO 2019/026927 A1 | 07 February 2019 | US 2020/0207953 A1<br>claims, examples<br>CN 110997796 A | |
| JP 2016-529205 A | 23 September 2016 | US 2016/0060281 A1<br>paragraph [0047], examples<br>WO 2014/179688 A1<br>EP 2991995 A1<br>TW 201500368 A<br>CA 2911382 A1 | |
| JP 63-145325 A | 17 June 1988 | (Family: none) | |
| US 2016/0289429 A1 | 06 October 2016 | WO 2017/171903 A1<br>CN 108778659 A<br>KR 10-2018-0128898 A<br>TW 201700575 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021047305 A
- JP H06128352 A
- WO 2011160916 A
- JP 4456478 B